# EUROPÄISCHE PATENTSCHRIFT

(11) **EP 0 439 667 B1**
(45) Veröffentlichungstag und Bekanntmachung des Hinweises auf die Patenterteilung: **03.02.1993**
(21) Anmeldenummer: 90109531.5
(22) Anmeldetag: 19.05.1990
(51) Int. Cl.: H02B 1/56, H05K 7/20

(54) **Filterlüfter für den Einbau in der Wand eines Schaltschrankes od. dgl.**
Ventilator filter for mounting in the wall of a switchgear cabinet or the like
Filtre de ventilateur pour le montage dans une paroi d'une armoire de commutation ou similaires

(30) Priorität: 02.02.1990 DE 9001174 U
(43) Veröffentlichungstag der Anmeldung: 07.08.1991
(73) Patentinhaber: OTTO PFANNENBERG ELEKTRO-SPEZIALGERÄTEBAU GMBH, 21007 Hamburg (DE)
(72) Erfinder: Bendt, Martin, D-2000 Hamburg 52 (DE)
(74) Vertreter: Richter, Werdermann & Gerbaulet

(56) Entgegenhaltungen:
- EP-A- 0 135 845
- DE-U- 8 707 975
- IBM TECHNICAL DISCLOSURE BULLETIN. vol. 32, no. 3A, August 1989, NEW YORK US Seiten 342 - 343; Armonk: "Pluggable Fan Assembly"

## Beschreibung

Die Erfindung betrifft einen Filterlüfter für den Einbau in der Wand eines Schaltschrankes od.dgl., wobei die Montagewand für den Filterlüfter mit einer Durchbrechung versehen ist, in der der Filterlüfter gehalten und befestigt ist.

Um die im Innenraum von z.B. elektronischen Steuereinrichtungen und Schaltungen enthaltenden Schaltschränken u.dgl. entstehende Wärme abzuführen, ist es bekannt, über ein Gebläse dem Schaltinnenraum kalte Frischluft zuzuführen. Das Gebläse ist dann in einer in der Schrankwand ausgebildeten Ausnehmung oder Ausschnitt mittels einer Schraubverbindung gehalten, während für den Luftaustritt an anderer Stelle der Schaltschrankwand Luftaustrittsschlitze oder Luftaustrittsfilter vorgesehen sind. Die Montage derartiger, mit einem Gebläse versehenen Filterlüfter an derartigen Schrankwänden ist oftmals mühevoll, da bei der Anwendung von Schraubverbindungen kaum Spielraum zur Verfügung steht, um den Filterlüfter auch noch nachträglich optisch ausrichten zu können. Auch können keine großen Spannbereiche überbrückt werden, um verschiedene Blechstärken der Montagewände zu berücksichtigen.

Durch die DE-A-3 710 566 ist ein Schaltschrank mit einem Klimagerät bekannt, bei dem die Deckwand des Schrankkorpus und die Unterseite des Klimagerätes mit aufeinander abgestimmten und ausgerichteten Durchbrüchen versehen und miteinander verbunden sind. Dabei ist mit der Deckwand des Schrankkorpus eine Zwischenplatte mit Durchbrüchen fest verbunden. Die Durchbrüche der Zwischenplatte sind auf die Durchbrüche in der Deckwand des Schrankkorpus abgestimmt und ausgerichtet. Die Zwischenplatte ist an drei Seiten mit einem hochgebogenen Rand versehen. Zum lösbaren Verbinden von Klimagerät und Zwischenplatte sind auf den Außenseiten der einander gegenüberliegenden Rändern der Zwischenplatte und den zugekehrten Außenseiten des in die Zwischenplatte eingeschobenen Klimagerätes aufeinander abgestimmte Verschlußteile von jeweils mindestens einem Schnellverschluß angebracht. Die hier verwendeten Schnellverschlüsse sind als manuell betätigbare Hebelverschlüsse ausgebildet.

Die DE-A-3 532 169 beschreibt einen Filter für die Kühlluft von elektrischen Geräten mit einem rahmenartigen, in einen Wandausschnitt des Gerätes von außen einsetzbaren Halteteil sowie mit einem Filtereinsatz, wobei das Halteteil von außen entriegelbare Verbindungselemente zum lösbaren Befestigen des Filter in dem Wandausschnitt aufweist. Als Verbindungslement zwischen dem Filter und der Seitenwand des Gerätes ist einerseits ein Schwenklager an der Unterseite des Halteteils sowie Rastlaschen am oberen Ende der Seitenwandteile vorgesehen. Das Schwenklager ist durch den an der Unterseite vorstehenden Rand und durch den Wandausschnitt dort hintergreifende Haltevorsprünge gebildet.

Die Rastlaschen tragen außenseitig jeweils einen Rastvorsprung, die in Schließstellung die Seitenwand bei dem Wandausschnitt hintergreifen. Die Rastlaschen befinden sich in einem die Seitenwandteile jeweils fortsetzenden Flansch, in dem von der Vorderseite her randoffene Einschnitte zur Bildung der etwa zungenförmigen Rastlaschen eingebracht sind und weisen eine nach vorne geführte Verlängerung mit einer insbesondere von Hand betätigbaren Druckstaste auf. Durch Druckbeaufschlagung der Drucktasten zueinander können die Rastvorsprünge außer Eingriff gebracht und anschließend das Filter um das Schwenklager herausgeschwenkt werden.

Ein Fassungsrahmen aus elastisch verformbarem, hochpolymerem Werkstoff zur abnehmbaren Halterung eines im wesentlichen starren, z.B. ein Meßgerät enthaltenden Aufnahmegehäuses im Ausschnitt einer Wand mit einer senkrecht zur Wand stehenden Rahmenwandung, die mit Anlageschultern an der Wand anliegt und deren Ausschnitt durchgreift, wobei Sperrzungen der Rahmenwandung nach außen aus der Ebene der Rahmenwandung herausragen, zu dieser Ebene hin elastisch eindrückbar und mit Gleitflächen versehen sind, die einen spitzen Winkel zur Ebene der Rahmenwandung einschließen und in Halterungsposition die Wand hintergreifen geht aus der DE-A-2 757 959 hervor. Als Kupplungsorgan des Meßinstrumentes an den Wandausschnitt dient hier ein Fassungsrahmen, der in etwa der geometrischen Form der Ausstanzung in der Wand, z.B. eines Schaltschrankes, entspricht. Die Rahmenwand trägt Sperrzungen, die aus der Ebene der Rahmenwand herausragen und die in Richtung dieser Ebene elastisch eindrückbar sind; ferner sind die Sperrzungen mit Gleitflächen versehen. Zum Verbinden rasten die Sperrzungen in Ausnehmungen in der Wand des Aufnahmegehäuses. Vermittels weiterer Sperrzungen erfolgt dann die Befestigung in der Wand des Schaltschrankes. Ein derart ausgebildeter Schnappverschluß vereinfacht gegenüber Schraubverbindungen eine Befestigung des Meßinstrumentes in einem Fassungsrahmen, denn das Meßinstrument wird lediglich in den Fassungsrahmen eingedrückt und danach das gesamte Aggregat zum Einrasten in die Wandung des Schaltschrankes gebracht, jedoch ist ein Anpassen dieses Schnappverschlusses an unterschiedliche Blechstärken der Montagewand und ein Ausrichten und Zentrieren nach erfolgem Einbau nicht mehr möglich.

In den Dokumenten "IBM Technical Disclosure Bulletin, Vol. 32 Nr. 3k, August 1989, Seiten 342-343" und DE-U-87 07 975 werden lediglich Schnappverschlüsse zur Befestigung von Axiallüfter beschrieben.

Der Erfindung liegt die Aufgabe zugrunde, einen Filterlüfter der eingangs genannten Art so auszubilden, daß eine Schnellmontage in den in den Montagewänden vorgesehenen Durchbrechungen, und zwar unabhängig von den vorgegebenen Materialstärken der Montagewände, möglich ist, wobei Fertigungstoleranzen der Montagewandausschnitte berücksichtigbar sind und außerdem ein nachträgliches Zentrieren des Filterlüfters möglich ist.

Diese Aufgabe wird durch die im Schutzanspruch 1 gekennzeichneten Merkmale gelöst.

Ein derart erfindungsgemäß ausgebildeter Filterlüfter, der aus einem Grundgehäuse mit Schnellbefestigungseinrichtungen, einem Abdeckgehäuse, einer Filtermatte und einem Gebläseträger besteht, weist eine geringe äußere Bauhöhe auf und steht somit nach erfolgtem Einbau in eine Montagewand, z.B. die Wand eines Schaltschrankes, nicht weit hervor. Alle Teile des Filterlüfters sind vormontiert .Beim Einbau wird er lediglich in die Öffnung der Montagewand hineingedrückt, wobei die Verbindung zwischen dem Grundgehäuse und dem Abdeckgehäuse mittels Klemmverbindungen erfolgt. Aufgrund der Rahmenbauweise für das Grundgehäuse und das Abdeckgehäuse sind beide Gehäuse so aneinander befestigbar, daß das Abdeckgehäuse mit der in diesem angeordneten Filtermatte in den Innenraum des Grundgehäuses einschiebbar ist, so daß die an dem Rahmen des Grundgehäuses angeformte Montagewandanlagekante an der umlaufenden Anlagekante am Rahmen des Abdeckgehäuse anliegt, wobei die Abmessungen der beiden Rahmen des Grundgehäuses und des Abdeckgehäuses derart gehalten sind, daß der Rahmen des Abdeckgehäuses bei der Montage in den vom Rahmen des Grundgehäuses umschlossenen Innenraum einführbar ist, so daß das Grundgehäuse mit dem Abdeckgehäuse eine Tiefe aufweist, die der Breite des Rahmens des Grundgehäuses zuzüglich der Wandstärke der Anlagekante am Rahmen des Abdeckgehäuses entspricht.

Die Befestigung des Filterlüfters erfolgt mittels der an seinem Grundgehäuse vorgesehenen Schnellbefestigungseinrichtung, die aus in den Eckbereichen des Rahmens des Grundgehäuses ausgebildeten flügelartigen Klemmabschnitten besteht, die aus den den Rahmen des Grundgehäuses bildenden Seitenwänden in Richtung zu den Eckbereichen flügelartig herausgestellt sind und somit aus der von den Seitenwänden des Rahmens des Grundgehäuses gebildeten Ebene herausragen. Die Montage des Filterlüfters ist sehr einfach. Das Grundgehäuse des Filterlüfters wird in den vorbereiteten Ausschnitt in der Montagewand eingeführt, wobei die Abmessungen des Ausschnittes in der Montagewand in etwa den Außenabmessungen des Rahmens des Grundgehäuses entsprechen. Beim Einsetzen des Grundgehäuses in den Ausschnitt in der Montagewand werden die flügelartigen Klemmabschnitte niedergedrückt und wenn der Rahmen mit seiner Montagewandanlagekante an der den Ausschnitt in der Montagewand begrenzenden Wandfläche zur Anlage gebracht ist, federn die flügelartigen Klemmabschnitte in ihre Ausgangslage zurück und verriegeln quasi das Grundgehäuse an der Montagewand, wobei die Wirkungsweise der flügelartigen Klemmabschnitte schnäpperartig ist. Auch ein Lösen des in eine Montagewand eingesetzten Filterlüfters ist mühelos. Zur Abnahme des Filterlüfters von der Montagewand werden mit einem geeigneten Werkzeug , wie Schraubendreher u.dgl., die flügelartigen Klemmabschnitte so weit niedergedrückt, bis diese flügelartigen Klemmabschnitte im Bereich des Ausschnittes liegen. Durch die Überführung der flügelartigen Klemmabschnitte aus ihren Verriegelungsstellungen in eingedrückte Stellungen wird die schnäpperartige Verbindung zur Montagewand gelöst und das Grundgehäuse kann leicht aus dem Ausschnitt in der Montagewand herausgenommen werden.

Durch die Ausgestaltung des Grundgehäuses des Filterlüfters mit schnäpperartig wirkenden Elementen ist eine Schnellmontage des Filterlüfters in Montagewänden möglich. Hinzu kommt, daß durch die konstruktive Ausgestaltung der einzelnen Bauteile des Filterlüfters dessen Bautiefe außerhalb als auch innerhalb des Schaltschrankes gering gehalten wird. Mit den herausgestellten flügelartigen Klemmabschnitten an den Seitenwänden des das Grundgehäuse bildenden Rahmens ist nicht nur eine Schnellmontage an Montagewänden möglich, sondern verschiedene Blechstärken der Montagewand können berücksichtigt werden, ohne daß es filterlüfterseitig einer Änderung bedarf. Das am Filterlüfter vorgesehene Einschnappsystem ermöglicht nach dem Einbau eine genaue optische Ausrichtung bzw. Zentrierung des Filterlüfters und da die flügelartigen Klemmabschnitte der vier Flügelecken am Rahmen des Grundgehäuses gleiche Klemmkräfte aufweisen, ist ein Zentrieren des Filterlüfters ohne Gehäuseverkantung möglich.

Vorteilhafte Ausgestaltungen der Erfindung sind in den Unteransprüchen gekennzeichnet.

Ausführungsbeispiele der Erfindung werden nachstehend anhand der Zeichnung näher erläutert. Es zeigen
Fig. 1 in einer Explosionsdarstellung den aus dem Grundgehäuse, dem Abdeckgehäuse und dem Gebläseträger bestehenden Filterlüfter,
Fig. 2 in einer schaubildlichen Ansicht den an einer Montagewand befestigten Filterlüfter in einer Variantenform,
Fig. 3 in einer vergrößerten schaubildlichen Ansicht den Eckbereich A des Filterlüfters gemäß Fig. 2,
Fig. 4 in eine Vorderansicht des Filterlüfters mit teilweise entfernten vorderen Abdeckgehäuse,
Fig. 5 eine Seitenansicht des Filterlüfters mit senkrecht geschnittenem Grundgehäuse und Abdeckgehäuse,
Figl 6 eine Außenansicht auf eine Flügelecke der Schnellbefestigungseinrichtung am Grundgehäuse des Filterlüfters und
Fig. 7 eine Innenansicht auf eine Flügelecke der Schnellbefestigung am Rahmen des Grundgehäuses des Filterlüfters.

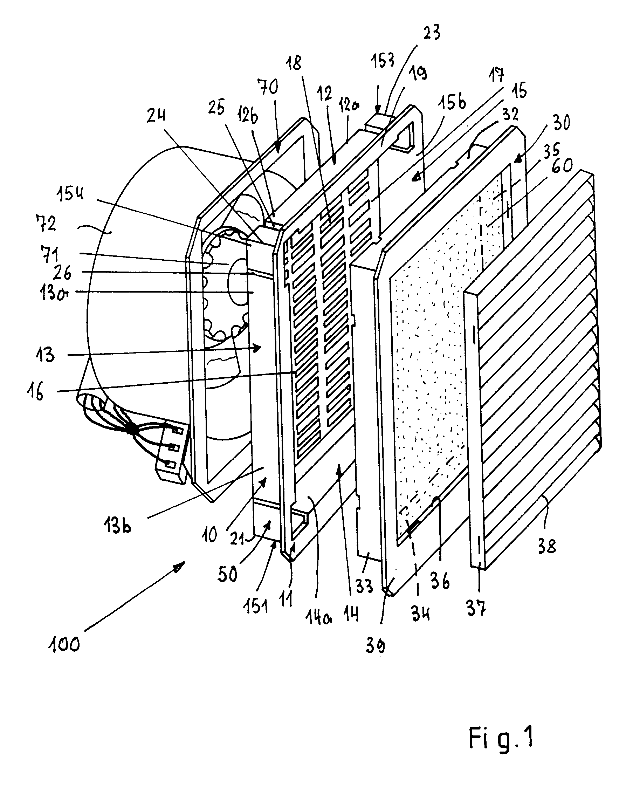

Der in den Fig. 1,2,4 und 5 dargestellte und mit 100 bezeichnete Filterlüfter besteht aus einem Grundgehäuse 10 mit einer Schnellbefestigungseinrichtung 50 zur Befestigung des Filterlüfters 100 im Ausschnitt oder einer Durchbrechung 81, einer Montagewand 80, einem in bzw. an dem Grundgehäuse 10 klemmend gehaltenen Abdeckgehäuse 30, einer in dem Abdeckgehäuse 30 angeordneten Filtermatte 60 und einem Gebläseträger 70 mit einem Gebläse 71, welches auch in einem Gehäuse 72 angeordnet sein kann.

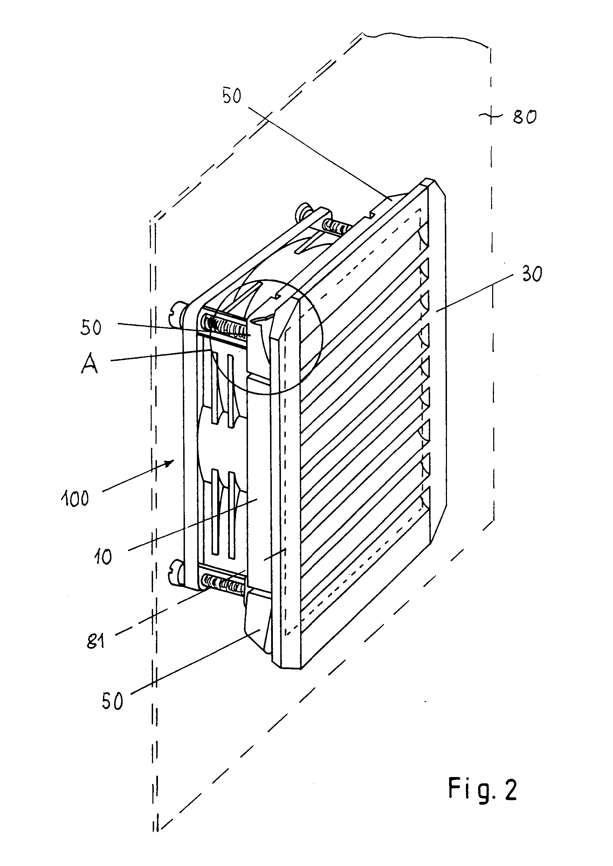

Das eine quadratische oder eine andere geometrische Form aufweisende Grundgehäuse 10 wird von einem Rahmen 11 mit vier Seitenwänden 12,13,14,15 gebildet. Die Endbereiche der Seitenwände 12 bis 15 sind mit 12a und 12b, 13a und 13b, 14a und 14b und 15a und 15b bezeichnet (Fig. 2).

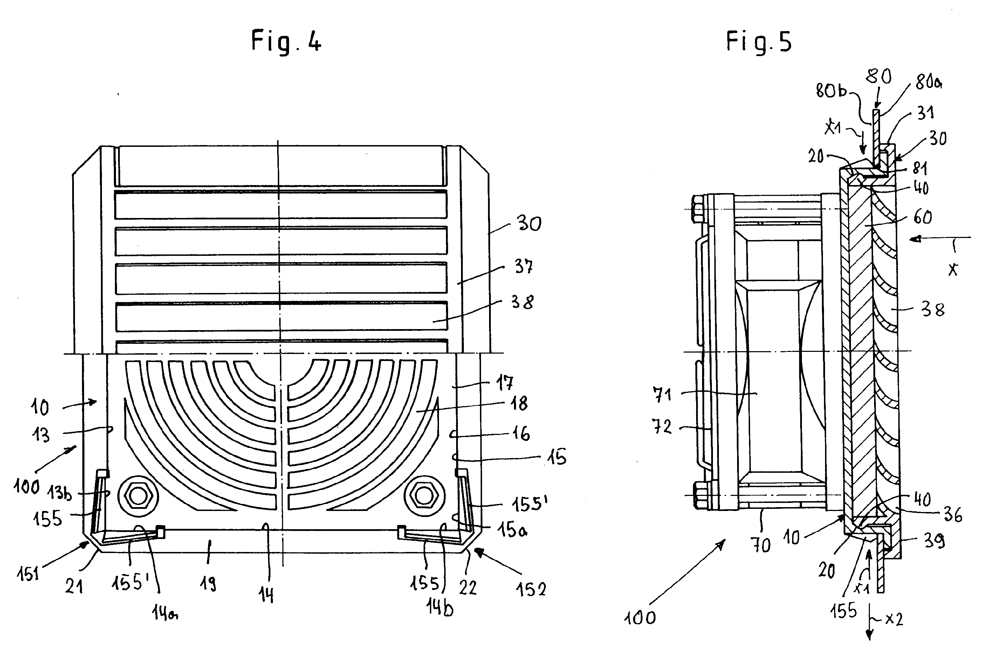

Die von dem Rahmen 11 des Grundgehäuses 10 gebildete Rahmenöffnung bzw. Durchbrechung 16 ist mittels eines plattenförmigen Zuschnittes 17 verschlossen, der als Berührungsschutzgitter 18 ausgebildet ist (Fig.4). Die

Ausbildung und Gestaltung des Berührungsschutzgitters 18 kann beliebig gewählt sein; wesentlich ist, daß eine ausreichende Anzahl von Durchbrechungen für eine Luftleitung bzw. -führung gegeben ist. Der Rahmen 11 mit dem plattenförmigen Zuschnitt 17 stellt vorzugsweise ein Formteil dar. Die Befestigung des plattenförmigen Zuschnittes 17 an den Seitenwänden 12 bis 15 des Rahmens 11 erfolgt vorzugsweise im mittleren Bereich der Seitenwände 12 bis 15 unter Freilassung und Ausbildung von Flügelecken 151,152, 153,154 in den Eckbereichen 21,22,23,24 des Rahmens 11, worauf nachstehend noch näher eingegangen wird.

Der plattenförmige Zuschnitt 17 ist bis über die Seitenwände 12 bis 15 des Rahmens 11 unter Ausbildung eines umlaufenden Abschnittes 17a verlängert.Dieser umlaufende Abschnitt 17a bildet die Anlagekante bzw. den Anlagerand 19 im Bereich der Durchbrechung 81 der Montagewand 80. Dieser umlaufende Randabschnitt 17a kann auch als gesonderter Anschlagrahmen an den Seitenwänden 12 bis 15 angeformt und nicht integrierter Bestandteil des plattenförmigen Zuschnittes 17 sein. Der Rahmen 11 mit den Seitenwänden 12 bis 15 und dem plattenförmigen Zuschnitt 17 mit dem Berührungsschutzgitter 18 sowie mit der Montagewandanlagekante 19 bilden ein einstückiges Bauteil, welches z.B. im Spritzgußverfahren hergestellt ist.

Das an dem Grundgehäuse 10 mittels Klemmsitz gehaltene Abdeckgehäuse 30 besteht aus einem Rahmen 31 mit den Seitenwänden 32,33,34,35, wobei dieser Rahmen 31 in Form und Abmessungen denen des Rahmens 11 des Grundgehäuses entspricht (Fig.1,2 und 5). Die Abmessungen des Rahmens 31 sind dabei so gehalten, daß das Abdeckgehäuse 30 mit seinem Rahmen 31 in den vom Rahmen 11 des Grundgehäuses 10 gebildeten Innenraum einführbar ist. Die Seitenwände 32 bis 35 liegen bei in das Grundgehäuse 10 eingesetztem Abdeckgehäuse 30 an den Innenwandflächen der Seitenwände 12 bis 15 des Rahmens 11 des Grundgehäuses 10 an.

Die von dem Rahmen 31 des Abdeckgehäuses 30 gebildete Öffnung 36 ist mittels einer Abdeckplatte 37 abgedeckt, die fester Bestandteil des Rahmens 31 , jedoch auch ein selbständiges Bauteil sein kann, das dann mittels Klemmsitz oder anderer geeigneter Verbindungsmittel in bzw. an dem Rahmen 31 des Abdeckgehäuses 30 gehalten ist. Diese Abdeckplatte 37 ist mit einer Anzahl von Luftleitschlitzen 38 oder mit andersartig ausgebildeten Durchbrechungen für eine Luftleitung und -führung versehen. Die Ausbildung der Luftleitschlitze 38 in der Abdeckplatte 37 erfolgt vorzugsweise durch eine jalousieklappenartige Ausgestaltung der Abdeckplatte mit feststehenden oder auch verstellbaren Klappen, wobei letztere Ausführungsform besonders vorteilhaft ist, wenn es sich um Filterlüfter 100 handelt, die größere Abmessungen aufweisen. Darüber hinaus besteht auch die Möglichkeit, die Abdeckplatte 37 mit andersartig ausgebildeten Durchbrechungen für eine Luftleitung bzw. -führung zu versehen; da nach erfolgtem Einbau des Filterlüfters 100 die Abdeckplatte 37 des auf das Grundgehäuse 10 aufgesetzten Abdeckgehäuses 30 eine Sichtfläche bildet, kann unter Ausbildung von Luftleitschlitzen oder Luftleitdurchbrechungen die Abdeckplatte 37 mit einem besonders gestalteten Design versehen sein.

Der Rahmen 31 des Abdeckgehäuses 30 ist mit einem senkrecht zu den Rahmenseitenwänden 32 bis 35 stehenden verlängerten Abschnitt versehen, der eine umlaufende Anlagekante 39 bildet, an der die Außenwandfläche des umlaufenden Abschnittes 17a des Rahmens 11 anliegt, wenn das Abdeckgehäuse 30 mit seinem Rahmen 31 in den Rahmen 11 des Grundgehäuses 10 eingeschoben ist. Die ausgebildete umlaufende Anlagekante 39 des Rahmens 31 des Abdeckgehäuses 30 kann an den Seitenwänden 32 bis 35 des Rahmens 31 angeformt sein; es besteht jedoch auch die Möglichkeit, diesen umlaufenden und die Anlagekante 39 bildenden Wandabschnitt durch eine entsprechend bemessene Abdeckplatte 37 zu schaffen, deren Abmessungen dann größer sind als die Außenabmessungen des Rahmens 31. Der umlaufende Rand dieses verlängerten, die Anlagekante 39 bildenden Abschnittes kann darüber hinaus noch in Richtung zum Rahmen 31 abgebogen sein, um den umlaufenden Rand des Abschnittes 17a des Rahmens 11 des Grundgehäuses 10 zu übergreifen, wenn das Grundgehäuse 10 mit dem Abdeckgehäuse 30 verbunden ist.

Die Halterung des Abdeckgehäuses 30 an dem Grundgehäuse 10 erfolgt vermittels einer Klemmverbindung, die von an den Außenwandflächen der Seitenwände 32 bis 35 des Rahmens 31 des Abdeckgehäuses 30 ausgebildeten Nocken 40 und entsprechend angeordneten und ausgebildeten Vertiefungen 20 an den Innenwandflächen der Seitenwände 12 bis 15 des Rahmens 11 des Grundgehäuses 10 gebildet wird, so daß beim Einführen des Rahmens 31 des Abdeckgehäuses 30 in den Rahmen 11 des Grundgehäuses 10 die Nocken 40 an dem Rahmen 31 in die entsprechend profilierten Vertiefungen 20 am Rahmen 11 des Grundgehäuses 10 eingreifen (Fig.5).

Der Rahmen 31 des Abdeckgehäuses 30 ist so bemessen, daß dieser eine in an sich bekannter Weise ausgebildete Filtermatte 60 aufnehmen kann, die einerseits an der Innenwandfläche der Abdeckplatte 37 und andererseits der Innenwandfläche des Berührungsschutzgitters 18 des Rahmens 11 des Grundgehäuses 10 anliegt, wenn das Grundgehäuse 10 mit dem Abdeckgehäuse 30 verbunden sind.

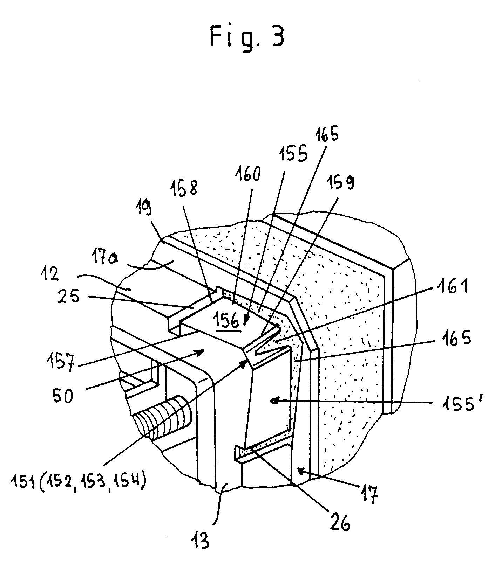

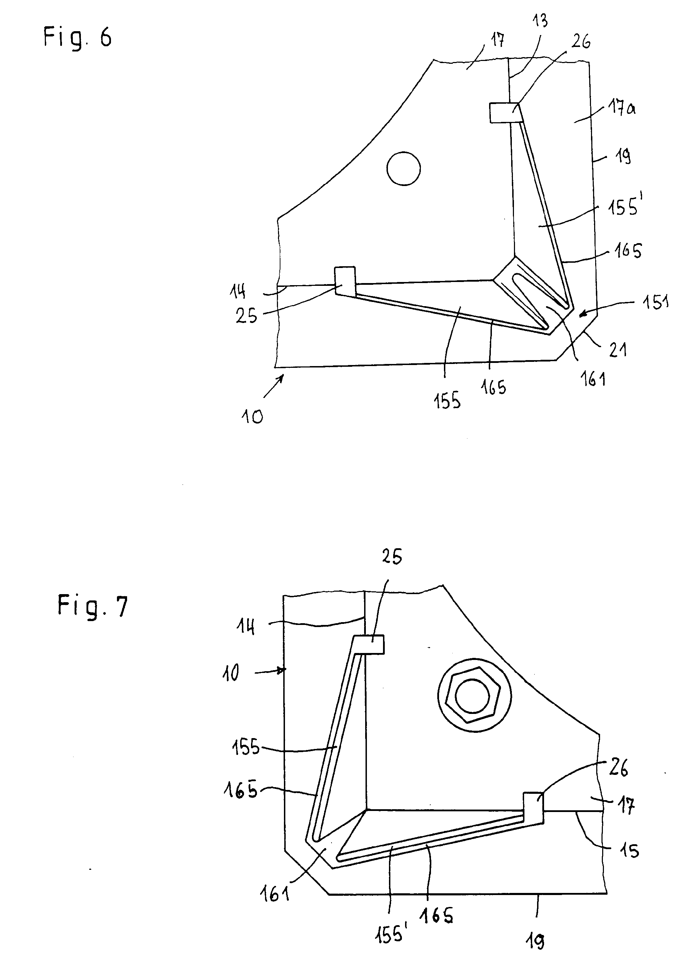

Die an dem Grundgehäuse 10 vorgesehene Schnellbefestigungseinrichtung 50 für den Filterlüfter 100 besteht aus in den vier Eckbereichen 21,22,23,24 des Rahmens 11 des Grundgehäuses 10 ausgebildeten federnd-elastischen Flügelecken 151,152,153,154. Jede Flügelecke 151,152,153,154 wird von zwei im rechten Winkel zueinanderstehenden, aus den Flächen der im Eckbereich 21,22,23,24 aneinandergrenzenden Rahmenseitenwänden 12,13 und 13,14 und 14,15 und 15,12 und in Richtung zu den Eckbereichen 21,22,23,24 aus den Ebenen der Rahmenseitenwände 12 bis 15 nach außen verlaufend herausgestellten, federnd-elastischen, flügelartigen Klemmabschnitten 155,155′ gebildet. Die Flügelecken 151 bis 154 in den Eckbereichen 21 bis 24 des Rahmens 11 sind alle gleich ausgebildet. Gleiche Ausbildung weisen auch die flügelartigen Klemmabschnitte 155,155′ der vier Flügelecken 151 bis 154 auf (Fig.3,6 und 7).

Die flügelartigen Klemmabschnitte 155,155′ einer jeden Flügelecke 151 bis 154 sind derart bemessen, daß zwischen deren oberen Kanten 160 und der die umlaufende Montagewandanlagekante 19 bildenden Wandfläche 17a ein Zwischenraum 165 ausgebildet ist (Fig.3,6 und 7).

Die flügelartigen Klemmabschnitte 155,155′ einer jeden Flügelecke 151 bis 154 sind in den Endbereichen 12a,12b und 13a,13b und 14a,14b und 15a,15b der Seitenwände 12 bis 15 des Rahmens 11 ausgebildet, so daß jede Seitenwand 12 bis 15 an ihren Endbereichen zwei flügelartige Klemmabschnitte 155 und 155′ trägt, wobei diese Klemmabschnitte 155,155′ selbst nicht mit den Seitenwänden 12 bis 15 in Verbindung stehen, sondern an dem Zuschnitt 17 des Rahmens 11 angeformt sind (Fig.3).

Da die beiden flügelartigen Klemmabschnitte 155,155′ gleich ausgebildet sind, wird nachstehend der flügelartige Klemmabschnitt 155 näher beschrieben. Dieser flügelartige Klemmabschnitt 155 besteht aus einem rechteckigen, plattenförmigen Zuschnitt 156 mit einer mit dem Grundgehäusezuschnitt 17 verbundenen Basiskante 157, zwei senkrecht auf dieser Basiskante 157 stehenden Seitenkanten 158,159 und einer oberen Seitenkante 160. Die Seitenkante 158 steht dabei in etwa im rechten Winkel zur Basiskante 157, wohingegen die Seitenkante 159 leicht nach außen ausgestellt ist (Fig.3),wobei auch beide flügelartigen Klemmabschnitte miteinander verbunden sein können. Des weiteren weist die Seitenkante 159 gegenüber der anderen Seitenkante 159 des plattenförmigen Zuschnittes 156 eine geringere Länge auf, so daß die obere Seitenkante 160 zur Basiskante 157 schräg verlaufend ist.

Die beiden derart ausgebildeten flügelartigen Klemmabschnitte 155,155′ sind in den Eckbereichen 21 bis 24, des Rahmens 11 in etwa im rechten Winkel zueinanderstehend so angeordnet, daß ihre Seitenkanten 159 unter Freilassung eines geringen Abstandes 161 sich gegenüberliegend sind. Darüber hinaus ist jeder flügelartige Klemmabschnitt 155 bzw. 155′ so bemessen, daß zwischen seiner oberen Seitenkante 160 und dem umlaufenden Abschnitt 17a mit der Montagewandanlagekante 19 ein Zwischenraum 165 gebildet wird, der in etwa der Materialstärke der Montagewand 80 entspricht. Beide flügelartigen Klemmabschnitte 155,155′ sind durch quer zur Längsrichtung der Seitenwände 12 bis 15 verlaufende Einschnitte 25,26 von den Seitenwänden 12 bis 15 des Rahmens 11 des Grundgehäuses 10 getrennt, so daß die Flügelecken 151 bis 154 ausgebildet und ein für sich federnd-elastisches Element mit den flügelartigen Klemmabschnitten 155,155′ bilden. Dieser Zwischenraum 165 ist in Richtung zur Seitenkante 159 des flügelartigen Klemmabschnittes konisch sich erweiternd, so daß im Bereich der Seitenkante 158 der Zwischenraum 165 eine geringere Breite gegenüber der Breite des Zwischenraumes im Bereich der Seitenkante 159 aufweist. Dadurch ist es möglich, eine klemmende Halterung an der Montagewand auch dann zu erreichen, wenn die Montagewand unterschiedliche Blechstärken aufweist.

Durch die Ausstellung der flügelartigen Klemmabschnitte 155,155′ aus der von den Seitenwänden 12 bis 15 des Rahmens 11 gebildeten Ebene bilden die Außenflächen der plattenförmigen Zuschnitte 156 der flügelartigen Klemmabschnitte 155,155′ Gleitflächen, wodurch das Einschieben des Grundgehäuses 10 in die Durchbrechung 81 in der Montagewand 80 erleichtert wird (Fig.5). Die Ausstellung der flügelartigen Klemmabschnitte 155,155′ erfolgt in Richtung zu demjenigen Bereich, in dem zwei flügelartige Klemmabschnitte 155,155′ einer jeden Flügelecke 151 bis 154 sich berühren,so daß die Ausstellung der flügelartigen Klemmabschnitte in Richtung zu den Eckbereichen in den oberen Bereichen der Klemmabschnitte erfolgt.

Das Grundgehäuse 10 und das Abdeckgehäuse 30 des Filterlüfters 100 bestehen vorzugsweise aus Kunststoffen, jedoch auch andersartige Werkstoffe können zur Herstellung dieser beiden Teile des Filterlüfters 100 herangezogen werden. Vorzugsweise werden solche Kunststoffe verwendet, die federnd-elastisch sind, um die federnd-elastische Wirkung der Flügelecken 151 bis 154 bzw. deren flügelartige Klemmabschnitte 155, 155′ zu bewirken. Es besteht jedoch auch die Möglichkeit, nur das Grundgehäuse 10 aus derartigen Kunststoffen herzustellen, da an dem Grundgehäuse 10 die Schnellbefestigungseinrichtung 50 angeordnet und ausgebildet ist. Wesentlich ist, daß die flügelartigen Klemmabschnitte 155, 155′ federnd-elastisch sind und wenn diese aus ihrer Grundstellung herausbewegt worden sind, wieder in ihre Grundstellung selbsttätig zurückfedern.

Der Einbau des Filterlüfters 100 in die Wand 80 eines in der Zeichnung nicht dargestellten Schaltschrankes od.dgl. wird wie folgt durchgeführt:
Die Wand 80, an der der Filterlüfter 100 befestigt werden soll, wird mit einer der Querschnittsform des Filterlüfters 100 entsprechenden Durchbrechung 81 versehen ( Fig.5). Die Abmessungen dieser Durchbrechung 81 entsprechen den Außenabmessungen des Rahmens 11 des Grundgehäuses 10. In diese Durchbrechung 81 wird das Grundgehäuse 10 mit seinem Rahmen 11 eingeführt, so daß der Rahmen 11 mit einem Abschnitt durch die Durchbrechung 81 in der Montagewand 80 hindurchgeführt ist. Das Einschieben des Rahmens 11 des Grundgehäuses 10 in die Durchbrechung 81 der Montagewand 80 erfolgt in Pfeilrichtung X. Da die flügelartigen Klemmabschnitte 155, 155′ der Schnellbefestigungseinrichtung 50 an dem Gehäuse 10 so ausgebildet und angeordnet sind, daß sich Gleitflächen ergeben, läßt sich der Rahmen 11 mühelos in die Durchbrechung 81 einführen, wobei gleichzeitig die flügelartigen Klemmabschnitte 155, 155′ in Pfeilrichtung X1 in die Ebene der Seitenwände 12 bis 15 des Rahmens 11 gedrückt werden. Die Abmessungen der Durchbrechung 81 in der Montagewand 80 sind so bemessen, daß im eingedrückten Zustand der flügelartigen Klemmabschnitte 155, 155′ der vier Flügelecken 151 bis 154 in die von den Seitenwänden 12 bis 15 des Rahmens 11 gebildete Ebene eingedrückt werden, um den Rahmen 11 an den die Durchbrechung 81 begrenzenden Rändern hindurchführen zu können.

Kommt der Rahmen 11 des Grundgehäuses 10 mit seiner Anlagekante 19 zur Anlage an der Außenwandfläche 80a der Montagewand 80, dann haben die flügelartigen Klemmabschnitte 155, 155′ eine Stellung erreicht, in der sie aus der niedergedrückten Stellung in ihre Ausgangsstellung zurückfedern, was in Pfeilrichtung X2 erfolgt, so daß die flügelartigen Klemmabschnitte 155, 155′ dann die in Fig. 5 wiedergegebene Stellung einnehmen, in der eine Verriegelung des Grundgehäuses 10 an der Montagewand 80 erfolgt. Der Gebläseträger 70 mit dem Gebläse 71 ist vor dem Einsetzen des Grundgehäuses 10 in die Durchbrechung 81 der Montagewand 80 bereits an dem Grundgehäuse 10 montiert, wobei die Abmessungen des Gebläseträgers 70 mit dem Gebläse 71 nicht über die Abmessungen des Rahmens 11 des Grundgehäuses 10 hinausgehen, so daß ein einwandfreies Hindurchführen des Gehäuseträgers 70 durch die Durchbrechung 81 in der Montagewand 80 beim Aufsetzen des Grundgehäuses 10 gewährleistet ist.

Nach der Verriegelung des Grundgehäuses 10 an der Montagewand 80 vermittels der flügelartigen Klemmabschnitte 155, 155′ kann noch ein Nachzentrieren erfolgen, falls dies erforderlich sein sollte. Hieraufhin wird das Abdeckgehäuse 30 mit eingelegter Filtermatte 60 aufgesetzt, so daß der Rahmen 31 des Abdeckgehäuses 30 in den Innenraum des Rahmens 11 eingeführt wird. Es kommt dann die Klemmverbindung 20, 40 zum Einsatz, wodurch das Abdeckgehäuse 30 an dem Grundgehäuse 10 gehalten ist.Das Abdeckgehäuse 30 stützt sich dann mit seiner Anlagekante 39 an der Außenwandfläche 80a der Montagewand 80 ab.

Auch wenn die Montagewand 80 unterschiedliche Materialstärken aufweist, ist eine sichere Befestigung des Filterlüfters 100 an der Montagewand 80 möglich. Weist die Montagewand 80 eine größere Materialstärke auf, dann federn die flügelartigen Klemmabschnitte 155,155′ an den Eckbereichen des Gehäuses 10 nicht in ihre Ausgangsstellung zurück, wenn diese durch eine geringere Materialstärke der Montagewand 80 vorgegeben ist. Die Klemmabschnitte 155,155′ federn nur dann so weit zurück bis diese zur Anlage an der Montagewand 80 kommen. Aufgrund der durch das Rückfederungsvermögen gegebenen Kräfte wird der Filterlüfter 100 an der Montagewand 80 gehalten.

## Patentansprüche

1. Filterlüfter für den Einbau in der Wand eines Schaltschrankes od.dgl., wobei die Montagewand für den Filterlüfter mit einer Durchbrechung versehen ist, in der der Filterlüfter gehalten und befestigt ist, dadurch gekennzeichnet, daß der Filterlüfter (100) aus
a) einem eine quadratische oder eine andere geometrische Form aufweisenden Grundgehäuse (10) mit einem Rahmen (11) mit vier Seitenwänden (12,13,14,15),dessen Rahmenöffnung (16) mittels eines Berührungsschutzgitters (18) verschlossen ist und der eine umlaufende Montagewandanlagekante (19) aufweist, wobei der Rahmen (11) an seinem Umfang mit einer schraubenlosen Schnellbefestigungseinrichtung (50) versehen ist,
b) einem auf dem Grundgehäuse (10) mittels Klemmsitz (20,40) gehaltenen Abdeckgehäuse (30) mit einer Anzahl von Luftleitschlitzen (38) oder Luftleitdurchbrechungen mit den verschiedensten geometrischen Formen,
c) einer zwischen dem Grundgehäuse (10) und dem Abdeckgehäuse (30) angeordneten und in diesem gehaltenen Filtermatte (60) und
d) einem an dem Grundgehäuse (10) an der dem Abdeckgehäuse (30) abgewandten Seite befestigten Gebläseträger (70) mit einem Gebläse (71)
besteht, wobei die Schnellbefestigungseinrichtung (50) aus in den vier Eckbereichen (21,22,23,24) des Rahmens (11) des Grundgehäuses (10) ausgebildeten, federndelastischen Flügelecken (151,152,153,154) besteht, von denen jede Flügelecke (151;152;153;154) von zwei im rechten Winkel zueinanderstehenden, aus den Flächen der im Eckbereich (21;22;23;24) aneinandergrenzenden Rahmenseitenwänden (12,13; 13,14;14,15;15,12)und in Richtung zu den Eckbereichen (21,22,23,24) aus den Ebenen der Rahmenseitenwände (12,13,14,15) nach außen verlaufend herausgestellten federnd-elastischen flügelartigen Klemmabschnitten (155,155′) gebildet ist, wobei die flügelartigen Klemmabschnitte (155,155′) derart bemessen sind, daß zwischen deren oberen Kanten (160) und der die umlaufende Montagewandanlagekante (19) bildenden Wandfläche ein Zwischenraum (165) ausgebildet ist.

2. Filterlüfter nach Anspruch 1, dadurch gekennzeichnet, daß der Filterlüfter (100) aus
a) einem eine quadratische oder eine andere geometrische Form aufweisenden Grundgehäuse (10), das von einem plattenförmigen Zuschnitt (17) mit einer mittels eines Berührungsschutzgitters (18) verschlossenen Durchbrechung (16), von einem an dem Zuschnitt (17) angeformten Rahmen (11) mit vier Seitenwänden (12,13, 14,15) und von einem im mittleren Bereich einer jeden Seitenwand (12;13;14;15) des Rahmens (11) angeformten, umlaufenden Anschlagrahmen als Montagewandanlagekante (19) gebildet ist, der gegenüber dem Rahmen (11) des Grundgehäuses (10) größere Abmessungen aufweist und der parallel zu dem Zuschnitt (17) verlaufend ist, wobei der Grundgehäuserahmen (11) an seinem Umfang mit einer schraubenlosen Schnellbefestigungseinrichtung (50) versehen ist,
b) einem auf dem Grundgehäuse (10) mittels Klemmsitz (20,40) gehaltenen Abdeckgehäuse (30) mit einer Anzahl von Luftleitschlitzen (38) oder Luftleitdurchbrechungen,
c) einer zwischen dem Grundgehäuse (10) und dem Abdeckgehäuse (30) angeordneten und in diesem gehaltenen Filtermatte (60) und
d) einem an dem Grundgehäuse (10) an der dem Abdeckgehäuse (30) abgewandten Seite befestigten Gebläseträger (70) mit einem Gebläse (71)
besteht, wobei die Schnellbefestigungseinrichtung (50) aus in den vier Eckbereichen (21,22,23,24) des Rahmens (11) des Grundgehäuses (10) ausgebildeten, federndelastischen Flügelecken (151,152,153,154) besteht, von denen jede Flügelecke (151;152;153;154) von zwei im rechten Winkel zueinanderstehenden, aus den im Eckbereich (21;22;23;24) aneinandergrenzenden Rahmenseitenwänden (12,13;13,14;14,15;15,12) geformten, federndelastischen, etwa rechteckförmigen, flügelartigen Klemmabschnitten (155,155′) besteht, die an dem Grundgehäusezuschnitt (17) angeformt sind und deren Flügelflächen in Richtung zu den Eckbereichen (21;22;23;24) aus den von den Rahmenseitenwänden (12,13,14,15) gebildeten Ebenen ansteigend verlaufend herausgeführt sind, wobei die flügelartigen Klemmabschnitte (155,155′) derart bemessen sind, daß zwischen deren oberen Kanten (160) und der die umlaufende Montagewandanlagekante (19) bildenden Wandfläche ein Zwischenraum (165) ausgebildet ist.

3. Filterlüfter nach Anspruch 1 oder 2, dadurch gekennzeichnet, daß das Grundgehäuse (10) und das Abdeckgehäuse (30) aus einem federnd-elastischen Material, wie Kunststoff od.dgl. bestehen.

4. Filterlüfter nach einem der Ansprüche 1 bis 3, dadurch gekennzeichnet, daß die flügelartigen Klemmabschnitte (155,155′) einer jeden Flügelecke (151;152;153;154) durch Einschnitte (25,26) in den beiden aneinandergrenzenden Rahmenseitenwänden (12,13;13,14;14,15; 15,12) ausgebildet und dadurch federnd-elastisch mit einem Rückstellvermögen sind.

5. Filterlüfter nach einem der Ansprüche 1 bis 4, dadurch gekennzeichnet, daß der flügelartige Klemmabschnitt (155;155′) einer jeden Flügelecke (151;152;153;154) von einem rechteckigen, plattenförmigen Zuschnitt (156) mit einer mit dem Grundgehäusezuschnitt (17) verbundenen Basiskante (157), einer senkrecht auf dieser stehenden Seitenkante (158), einer im Winkel nach außen geneigt stehenden Seitenkante (159) mit einer gegenüber der Länge der senkrechten Seitenkante (158) geringeren Länge, und mit einer die beiden Seitenkanten (158,159) miteinander verbindenden oberen Seitenkante (160) gebildet ist, die zur Basisseitenkante (157) und in Richtung zu der Seitenkante (159) schräg verlaufend ist, wobei die Anordnung der beiden flügelartigen Klemmabschnitte (155,155′) einer jeden Flügelecke (151;152;153;154) derart ist, daß die kürzeren Seitenkanten (159) der beiden flügelartigen Klemmabschnitte (155,155′) benachbart zueinanderliegend und in einem geringen Abstand (161) voneinander angeordnet sind.

6. Filterlüfter nach Anspruch 5, dadurch gekennzeichnet, daß der Abstand (161) gegen Null gehend ist.

7. Filterlüfter nach einem der Ansprüche 1 bis 6, dadurch gekennzeichnet, daß das Abdeckgehäuse (30) aus einem die Filtermatte (60) aufnehmenden Rahmen (31) und einer in dem Rahmen (31) mittels Klemmsitz gehaltenen Abdeckplatte (37) besteht, die Luftleitschlitze (38) oder -durchbrechungen aufweist.

8. Filterlüfter nach einem der Ansprüche 1 bis 7, dadurch gekennzeichnet, daß der Zwischenraum (165) zwischen der oberen Kante (160) eines jeden flügelartigen Klemmabschnittes (155,155′) und der die umlaufende Montagewandanlagekante (165) begrenzenden Wandfläche sich in Richtung zur Seitenkante (159) des flügelartigen Klemmabschnittes konisch erweiternd ist.

## Claims

1. Ventilator filter for mounting in the wall of a switchgear cabinet or the like, in which the mounting wall for the ventilator filter is provided with an opening wherein the ventilator filter is retained and secured,
characterized in that
the ventilator filter (100) comprises
a) a basic casing (10) possessing a square or some other geometric configuration, having a frame (11) with four sidewalls (12,13,14,15), the frame aperture (16) of which is closed by means of a voltage-proof protective grating (18) and which possesses a circumferential mounting wall stop edge (19), while the frame (11), on its circumference, is provided with a screwless rapid attachment means (5);
b) a covering casing (30) retained on the basic housing (10) by means of a clamp fit (20,40) having a plurality of air-conducting slots (38) or air-conducting perforations possessing the most widely varying geometric configurations;
c) a filter mat (60) disposed between the basic housing (10) and the covering casing (30) and retained in the latter, and
d) a blower support (70) with a blower (71) attached on the basic casing (10) on the side which faces away from the covering casing (30);
wherein the rapid attachment means (50) is constituted of springily-elastic wing-like corners (152,152,153,154) made up within the four corner areas (21,22,23,24) of the frame (11) of the basic housing (10), of which each wing-like corner (151;152;153;154)is made up of the surface areas of the frame side walls (12,13;13,14;14,15;15,12) disposed at right angles to each other and adjoining each other from the surfaces of the frame side walls (12,13;13,14; 14,15;15,12) and, in the direction towards the corner areas (21,22,23,24), is formed of the springily-elastic wing-like clamping sections (155,155′) which proceed outwardly brought out from the planes of the frame side walls (12,13,14,15), the wing-like clamping sections (155,155′) being dimensioned in such a way that, between their upper edges (160) and the wall area constituting the circumferential mountinh wall stop edge (19), an interspace is formed.

2. Ventilator filter according to Claim 1, characterized in that the ventilator filter (100) comprises
a) a basic casing (10) possessing a square or other geometric configuration, which is formed by a plate-shaped blank (17) having an opening (16) which is closed with the aid of a voltage-proof protective grating (18), a frame (11) with four side walls (12,13,14,15) formed on to the blank (17) and a circumferential stop frame formed on within the central area of each side wall (12;13;14;15) of the frame (11) in the form of a mounting wall stop edge (19), which, in comparison with the frame (11) of the basic casing (10), possesses larger dimensions and which proceeds parallel to the blank (17), in which the basic casing frame (11), on its circumference, is provided with a screwless rapid attachment means (50);
b) a covering casing (30) retained on the basic casing (10) by means of a clamp fit (20,40) and having a plurality of air-conduction slots (38) or air-conducting perforations;
c) a filter mat (60) disposed between the basic casing (10) and the covering casing (30), and
d) a blower support (70) with a blower (71) attached on the side which faces away from the covering casing (30),
wherein the rapid attachment means (50) is constituted of the springily-elastic, wing-like corners (151,152,153,154) formed within the four corner areas (21,22,23,24) of the frame (11) of the basic casing (10), of which each wing-like corner (151;152;153;154) is constituted of two springily-elastic, approximately rectangular, wing-like clamping sections (155,155′) formed of two adjoining frame side walls (12,13;13,14;14,15;15,12) arranged at right angles to each other that are formed on to the basic casing blank (17) and whose wing-like areas, in the direction towards the corner areas (21;22;23;24), are brought out so as to proceed ascendingly from the planes formed by the frame side walls (12,13,14,15), the wing-like clamping sections (155, 155′) being dimensioned in such a way that, between their upper edges (160) and the wall area constituting the circumferential mounting wall stop edge (19), an interspace (165) is formed.

3. Ventilator filter according to either Claim 1 or 2, characterized in that the basic casing (10) and the covering casing (30) consist of a springily-elastic material, such as a plastic or the like.

4. Ventilator filter according to any of the Claims 1 to 3, characterized in that the wing-like clamping sections (155, 155′) of each wing-like corner (151;152;153;154) are formed by slot-like recesses (25,26) in the two adjoining frame side walls (1213;13,14;14,15;15,12) and, thereby, are springily-elastic and possess an elastic recovery capacity.

5. Ventilator filter according to any of Claims 1 to 4, characterized in that the wing-like clamping section (155,155′) of each wing-like corner (151;152;153;154) is constituted of a rectangular, plate-like blank (156) having a besic edge (157) connected with the basic casing blank (17), a Lateral edge (158) disposed vertically on the latter, a lateral edge (159) arranged at an outwardly inclined angle possessing a length which is shorter than the length of the vertical lateral edge (158), and an upper lateral edge (160) which interconnects the two lateral edges (158,159), which proceeds obliquely to the basic lateral edge (157) and in the direction towards the lateral edge (159), in which the disposition of the two wing-like clamping sections (155,155′) of each wing-like corner (151;152;153,154) being such that the shorter lateral edges (159) of the two wing-like clamping sections (155,155′) are disposed so as to be located adjacent to each other and at a short distance (161) from each other.

6. Ventilator filter according to Claim 5, characterized in that the distance (161) narrows down to zero.

7. Ventilator filter according to any of Claims 1 to 6, characterized in that the covering casing (30) consists of a frame (31) accommodating the filter mat (60) and a covering plate (37) retained by means of a clamping fit in the frame (31) and possesses air-conducting slots (38) or air-conducting perforations.

8. Ventilator filter according to any of Claims 1 to 7, characterized in that the interspace (165) between the upper edge (160) of each wing-like clamping section (155,155′) and the wall area delimiting the circumferential mounting wall stop edge (165) expands conically in the direction towards the lateral edge (159) of the wing-like clamping section.

## Revendications

1. Ventilateur à filtre pour le montage dans la paroi d'une armoire de commande ou similaire, la paroi de montage pour le ventilateur à filtre étant pourvue d'une découpure dans laquelle le ventilateur à filtre est maintenu et fixé, caractérisé en ce que le ventilateur à filtre (1) est constitué par
a) un bâti de base (10), qui présente une forme carrée ou une autre forme géométrique, avec un cadre (11) avec quatre parois latérales (12, 13, 14, 15) dont l'ouverture de cadre (16) est fermée par une grille de protection contre les contacts accidentels (18) et qui présente un bord d'appui périphérique (19) contre la paroi de montage, le cadre (11) étant pourvu à sa périphérie d'un dispositif d'assemblage rapide sans vis (50),
b) un bâti de recouvrement (30) maintenu sur le bâti de base (10) par un ajustement serré (20, 40) avec un certain nombre de fentes de conduction d'air (38) ou de découpures de conduction d'air avec les formes géométriques les plus diverses.
c) un tapis filtrant (60) placé entre le bâti de base (10) et le bâti de recouvrement (30) et maintenu dans celui-ci et
d) un support de soufflante (70) avec une soufflante (71) qui est fixé sur le bâti de base (10) sur le côté opposé au bâti de recouvrement (30),
le dispositif d'assemblage rapide (50) étant constitué par des coins en ailes (151, 152, 153, 154), élastiques comme des ressorts, qui sont formés dans les quatre zones de coin (21, 22, 23, 24) du cadre (11) du bâti de base (10), chaque coin en aile (151, 152, 153, 154) étant formé par deux sections de serrage du type aile (155, 155′), élastiques comme des ressorts, formant un angle droit l'une avec l'autre, sortant à partir des surfaces des parois latérales de cadre (12, 13 ; 13, 14 ; 14, 15; 15, 12) contiguës dans la zone de coin (21, 22, 23, 24) et vers l'extérieur en direction des zones de coin (21, 22, 23, 24) à partir des plans des parois latérales de cadre (12, 13, 14, 15), les sections de serrage du type aile (155, 155′) étant dimensionnées de manière telle qu'un espace intermédiaire (165) est formé entre leurs bords supérieurs (160) et la face de paroi qui forme le bord d'appui périphérique contre la paroi de montage (19).

2. Ventilateur à filtre selon la revendication 1, caractérisé en ce que le ventilateur à filtre (100) est constitué par
a) un bâti de base (10) qui présente une forme carrée ou une autre forme géométrique qui est formé par une pièce découpée en forme de plaque (17) avec une découpure (16) fermée par une grille de protection contre les contacts accidentels (18), par un cadre (11) avec quatre parois latérales (12, 13, 14, 15) moulé sur la pièce découpée (17) et par un cadre de butée comme bord d'appui contre la paroi de montage, moulé dans la zone centrale de chaque paroi latérale (12, 13, 14, 15) du cadre (11), cadre de butée qui présente des dimensions supérieures à celle du cadre (11) du bâti de base (10) et qui est parallèle à la pièce découpée (17), le cadre du bâti de base (11) étant pourvu à sa périphérie d'un dispositif d'assemblage rapide sans vis (50),
b) par un bâti de recouvrement (30), avec un certain nombre de fentes de conduction d'air (38) ou de découpures de conduction d'air, maintenu sur le bâti de base (10) par un ajustage serré (20, 40),
c) par un tapis filtrant (60) placé entre le bâti de base (10) et le bâti de recouvrement (30) et maintenu dans celui-ci et
d) par un support de soufflante (70), avec une soufflante (71), fixé sur le bâti de base (10) du côté opposé au bâti de recouvrement (30),
le dispositif d'assemblage rapide (50) étant constitué par des coins en ailes (151, 152, 153, 154), élastiques comme des ressorts, qui sont formés dans les quatre zones de coin (21, 22, 23, 24) du cadre (11) du bâti de base (10), chaque coin en aile (151, 152, 153, 154) étant formé par deux sections de serrage du type aile (155, 155′) à peu près rectangulaires, élastiques comme des ressorts, formant un angle droit l'une avec l'autre, moulées à partir des parois latérales de cadre (12, 13 ; 13, 14 ; 14, 15; 15, 12) contiguës dans la zone de coin (21, 22, 23, 24) qui sont moulées sur la pièce découpée du bâti de base (17) et dont les surfaces d'aile sortent en montant en direction des zones de coin (21, 22, 23, 24) à partir des plans formés par les parois latérales de cadre (12, 13, 14, 15), les sections de serrage du type aile (155, 155′) étant dimensionnées de manière telle qu'un espace intermédiaire (165) est formé entre leurs bords supérieurs (160) et la face de paroi qui forme le bord d'appui périphérique contre la paroi de montage (19).

3. Ventilateur à filtre selon la revendication 1 ou 2, caractérisé en ce que le bâti de base (10) et le bâti de recouvrement (30) sont constitués par une matière élastique comme un ressort comme le plastique ou équivalent.

4. Ventilateur à filtre selon l'une des revendications 1 à 3, caractérisé en ce que les sections de serrage du type aile (155, 155′) de chacun des coins en aile (151, 152, 153, 154) sont formées par des entailles (25, 26) dans les deux parois latérales de cadre contiguëes (12, 13; 13, 14; 14, 15; 15, 12) et sont donc élastiques comme des ressorts avec une force de rappel.

5. Ventilateur à filtre selon l'une des revendications 1 à 4, caractérisé en ce que la section de serrage du type aile (155, 155′) de chacun des coins en aile (151, 152, 153, 154) est formée par une pièce découpée (156) en forme de plaque rectangulaire avec un bord de base (157) relié à la pièce découpée du bâti de base (17), avec un bord latéral (158) perpendiculaire à ce bord de base, un bord latéral (159) vertical incliné vers l'extérieur en formant un angle d'une longueur inférieure à celle du bord latéral vertical (158) et avec un bord latéral supérieur (160) qui relie les deux bords latéraux (158, 159) l'un à l'autre qui est en biais par rapport au bord latéral de base (157) en direction du bord latéral (159), la disposition des deux sections de serrage du type aile (155, 155′) de chacun des coins en aile (151, 152, 153, 154) étant telle que les bords latéraux les plus courts (159) des deux sections de serrage de type aile (155, 155′) étant voisins l'un de l'autre et placés à une faible distance (161) l'un de l'autre.

6. Ventilateur à filtre selon la revendication 5, caractérisé en ce que la distance (161) tend à être nulle.

7. Ventilateur à filtre selon l'une des revendications 1 à 6, caractérisé en ce que le bâti de recouvrement (30) est constitué par un cadre (31) qui reçoit le tapis filtrant (60) et par une plaque de recouvrement (37), maintenue dans le cadre (31) par un ajustement serré, qui présente des fentes ou découpures de conduction d'air (38).

8. Ventilateur à filtre selon l'une des revendications 1 à 7, caractérisé en ce que l'espace intermédiaire (165) entre le bord supérieur (160) de chacune des sections de serrage de type aile (155, 155′) et la face de paroi qui délimite le bord d'appui périphérique (165) contre la paroi de montage est évasé de manière conique en direction du bord latéral (159) de la section de serrage de type aile.
